# EUROPEAN PATENT APPLICATION

(11) **EP 1 655 994 A2**
(43) Date of publication of application: **10.05.2006**
(21) Application number: 05022900.4
(22) Date of filing: 20.10.2005
(51) Int. Cl.: H04R 7/04

(54) **Flat panel speaker**

(30) Priority: 28.10.2004 JP 2004314333
(71) Applicant: HOSIDEN CORPORATION, Yao-shi, Osaka 581-0071 (JP)
(72) Inventor: Kamimura, Tomohiko, Habikino-shi Osaka 583-0852 (JP); Fujiwara, Satoru, Izumi-shi Osaka 594-0032 (JP); Fuji, Eiki, Yao-shi Osaka 581-0802 (JP)
(74) Representative: Hoffmann, Eckart

(57) **Abstract**

A flat panel speaker has a construction in which an actuator 10 vibrates a panel 21 to radiate sound, the panel 21 being held at a peripheral portion thereof on a frame 22 by gaskets, wherein the gasket 31 provided at a position opposite from a position at which the actuator 10 is placed has a higher hardness than that of the gasket 32 provided at another position. The side on which the gasket 31 having the higher hardness is placed is a substantially fixed end to facilitate vibration of the panel 21, thereby improving sound quality.

## Description

### BACKGROUND OF THE INVENTION

The present invention relates to a flat panel speaker having a structure for radiating sound from a panel by vibrating the panel by means of an actuator.

Flat panel speakers of this type are being used, for example, in devices such as portable telephones, personal data assistances (PDAs), and personal computers. In such a flat panel speaker there is used, as a diaphragm, a transparent panel (flat panel) placed on a surface of such device to cover a screen of a display device such as a liquid crystal display.

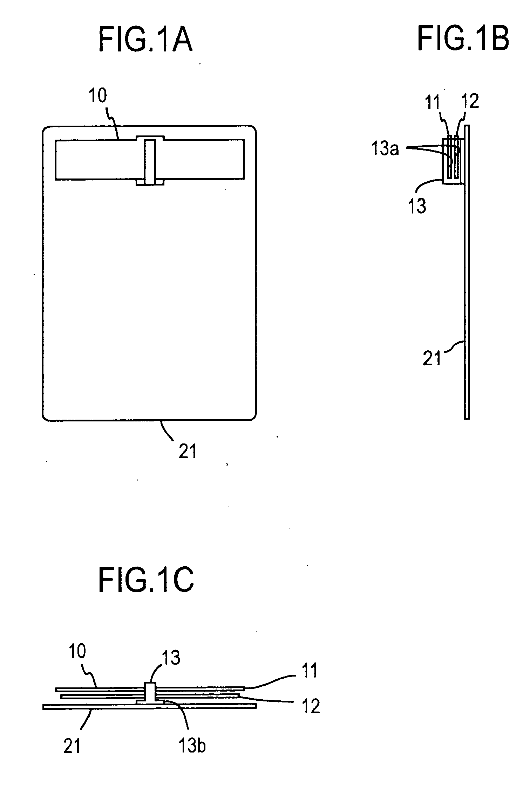

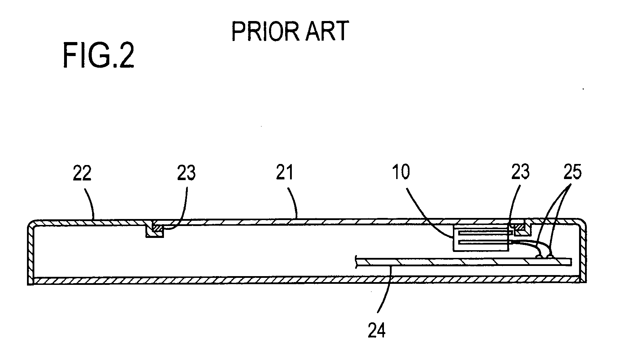

Figs. 1A, 1B, and 1C and Fig. 2 show the construction of an example of such conventional flat panel speakers described in Japanese Patent Application Laid-Open No. 2004-104327 (published on April 2, 2004, hereinafter referred to as document 1). Figs. 1A, 1B, and 1C show a panel to which an actuator is attached, and Fig. 2 schematically shows a state in which the panel to which the actuator is attached is mounted in a portable telephone.

In the actuator 10 in this example, two piezoelectric vibrating plates 11 and 12 having different lengths from each other are held in parallel with each other on a holder 13, as shown in Figs. 1A, 1B, and 1C. Each of the piezoelectric vibrating plates 11 and 12 has a laminated structure (not shown in detail), so-called bimorph type, that comprises a pair of piezoelectric elements sandwiching an electrode in a form of plate, and further electrodes placed outside the piezoelectric elements. A ceramic such as lead zirconate titanate (PZT) is used for the piezoelectric element.

The holder 13 has two slits 13 a sandwiching the piezoelectric vibrating plates 11 and 12. The piezoelectric vibrating plates 11 and 12 are inserted in these slits 13a and fixed in the same by bonding, with center portions thereof in the longitudinal direction being held in the holder 13. The holder 13 has a large-width base portion 13b at one end in the direction of lamination of the piezoelectric vibrating plates 11 and 12. An end surface (bottom surface) of the base portion 13b parallel to the surfaces of the piezoelectric vibrating plates 11 and 12 is attached to the panel.

The actuator 10 is placed along one side of the panel 21, as shown in Fig. 1A, and is mounted on the panel 21 by attaching the base portion 13b of the holder 13 to the panel 21. The panel 21 is formed of a plate made of a transparent resin, e.g., a polycarbonate or acrylic resin.

The panel 21 on which the actuator 10 is mounted is placed in a surface of the portable telephone, with its peripheral portion secured on a frame 22 of the portable telephone, as shown in Fig. 2. A gasket 23 is interposed between the peripheral portion of the panel 21 and the frame 22 through the entire periphery. The panel 21 is held on the frame 22 by means of the gasket 23. In Fig. 2, reference numeral 24 denotes a printed circuit board, and reference numeral 25 denotes lead wires for connecting the actuator 10 to the printed circuit board 24. A display device, e.g., a liquid crystal display device (not shown) is mounted on the printed circuit board 24.

When a voice signal is input to the actuator 10 in the flat panel speaker having the above described construction, the piezoelectric vibrating plates 11 and 12 vibrate. The vibrations are transmitted as waves to the panel 21 through the holder 13 to radiate sound through the entire panel 21. The gasket 23 interposed between the panel 21 and the frame 22 can reduce vibrations transmitted to the frame 22 and increase the amplitude of vibration of the panel 21.

In the flat panel speaker having such a structure described above, acoustic characteristics vary largely depending on the material, shape and thickness of the panel used as a diaphragm and are generally determined by the specifications of the panel. However, there are restrictions on the shape, size and so on, of the panel incorporated in the frame. There are also restrictions on the essential functions of the panel. Therefore, the specifications of the panel cannot be determined only with respect to the acoustic characteristics. Further, there are few methods for adjusting the acoustic characteristics of the flat panel speaker because of the construction in which the actuator is simply adhered to the panel.

### SUMMARY OF THE INVENTION

An object of the present invention is to provide a flat panel speaker which is constructed so that acoustic characteristics can be adjusted, and which can, therefore, radiate sound of improved quality in comparison with the conventional art.

According to the present invention, there is provided a flat panel speaker having a construction in which an actuator vibrates a panel to radiate sound, the panel being held at a peripheral portion thereof on a frame by gaskets, wherein the gasket provided at a position opposite from a position at which the actuator is placed has a higher hardness than that of the gasket provided at another position.

In the flat panel speaker of the present invention employing the above-described construction, the side on which the gasket having the higher hardness is placed is close to a fixed end, or a substantially fixed end to facilitate vibration of the panel, thereby improving the sensitivity in a low frequency range and reducing distortion in the low frequency range. In these respects, sound quality can be improved.

### BRIEF DESCRIPTION OF THE DRAWINGS

Fig. 1A is a plan view of a flat panel speaker, in which an actuator is attached to a panel;
Fig. 1B is a side view as seen from the right-hand side of Fig. 1A;
Fig. 1C is a view as seen from the front side of Fig. 1A;
Fig. 2 is a sectional view of the conventional flat panel speaker mounted in a frame;
Fig. 3A is a sectional view of an embodiment of a flat panel speaker in accordance with the present invention mounted in a frame;
Fig. 3B is a plan view of the flat panel speaker shown in Fig. 3A;
Fig. 4 is a diagram schematically showing a vibrating state of the panel shown in Fig. 3A;
Fig. 5 is a plan view of another embodiment of the present invention in which the area in which a gasket having a higher hardness is placed is increased;
Fig. 6A is a graph showing acoustic characteristics (sensitivity) of the flat panel speaker of the present invention shown in Figs. 3A and 3B and the conventional flat panel speaker in comparison with each other; and
Fig. 6B is a graph showing acoustic characteristics (total harmonic distortion factors) of the flat panel speaker of the present invention shown in Figs. 3A and 3B and the conventional flat panel speaker in comparison with each other.

### DETAILED DESCRIPTION OF THE PREFERRED EMBODIMENTS

An embodiment of the present invention will be described below.

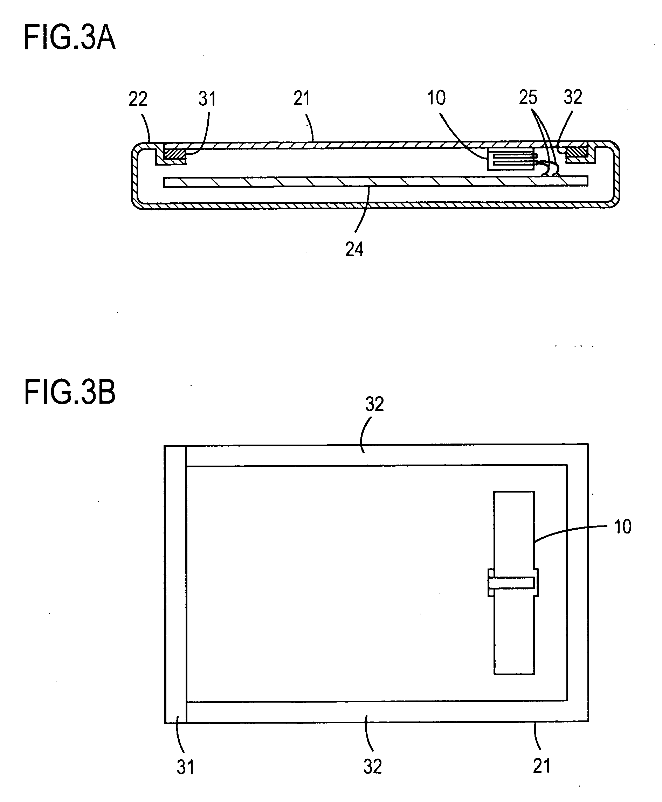

Figs. 3A and 3B show an embodiment of a flat panel speaker in accordance with the present invention. Fig. 3A schematically shows a state in which the flat panel speaker is incorporated in an appliance such as a portable telephone, and Fig. 3B shows a state in which an actuator and gaskets are attached to a panel. Parts corresponding to those shown in Figs. 1A, 1B, and 1C and Fig. 2 are indicated by the same reference numerals, and the detailed description for them will not be repeated.

In this embodiment, there are used, instead of a single gasket of one type as in the conventional art, two gaskets 31 and 32 having different hardnesses from each other are placed along the periphery of the panel 21 and interposed between the panel 21 and the frame 22.

The panel 21 in this embodiment is rectangular and the actuator 10 is placed along one side of the panel 21 and adhered to the panel 21, as shown in Fig. 3B. The (hard) gasket 31 having a higher hardness is placed at a position opposite from the side for the placement of the actuator 10, i.e., on the other side opposite from the side of the panel 21 along which the actuator 10 is placed, while the (soft) gasket 32 having a lower hardness than the gasket 31 are placed at the other positions.

The gaskets 31 and 32 interposed between the panel 21 and the frame 22 are attached to peripheral portions of the panel 21, as shown in Fig. 3B. The panel 21 to which the gaskets 31, 32 and the actuator 10 are attached is assembled to the frame 22 and the gaskets 31 and 32 are attached to the frame 22. The panel 21 is thus mounted in the frame 22. The attachment of the gaskets 31 and 32 to the panel 21 and the attachment of the gaskets 31 and 32 to the frame 22 are provided by means of a double-sided pressure-sensitive adhesive tape, for example.

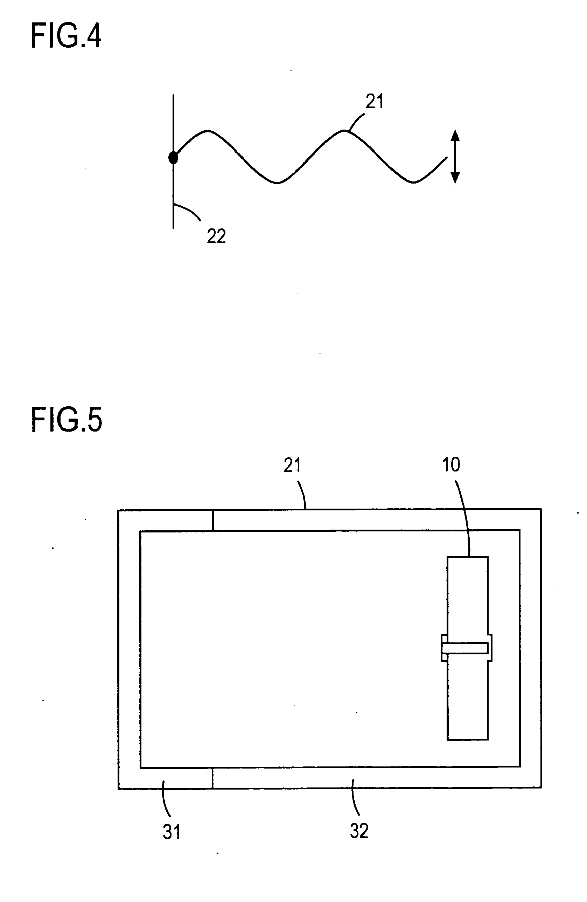

In the flat panel speaker having such a construction described above, the side of the panel 21 on which the gasket 31 having the higher hardness is placed is close to a fixed end, i.e., a substantially fixed end to facilitate vibration of the panel 21. Fig. 4 schematically shows the state of vibration of the panel 21 in such supported state.

Each of the gaskets 31 and 32 having different hardnesses from each other is formed of a polyurethane foam in this embodiment, with their material densities being different by a factor of two.

Fig. 5 shows another embodiment in which the gasket 31 having the higher hardness is placed along one side of the rectangular panel 21 as shown in Fig. 3B, and, additionally, the placement area thereof is increased. The gasket 31 having the higher hardness may be placed in a U-shaped configuration, as in this example, to adjust vibration modes of the panel 21. However, the area in which the gasket 31 having the higher hardness is placed is defined not to exceed the half of the entire periphery in the design to achieve a good operating condition of the panel 21.

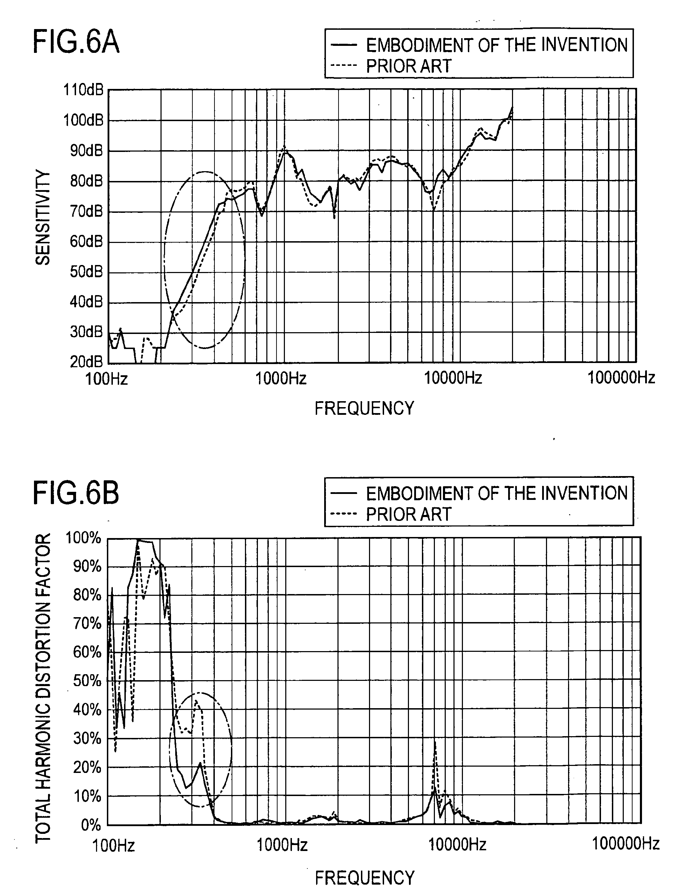

Figs. 6A and 6B show data on acoustic characteristics of the flat panel speaker (the embodiment of the present invention) in which two types of gaskets 31 and 32 having different hardnesses are disposed as shown in Figs. 3A and 3B and data on acoustic characteristics of the conventional speaker (prior art) using one type of gasket in comparison with each other. Fig. 6A shows the sensitivity, and Fig. 6B shows the total harmonic distortion (THD) factor. Portions of the data surrounded by the dot-dash line indicate prominent differences in the characteristics.

It can be understood from Figs. 6A and 6B that the sensitivity in a low frequency range is increased and the distortion factor in the low frequency range is reduced in the embodiment of the present invention in comparison with the prior art. Also, the resonance frequency (F₀) can be moved to a lower frequency. As a result, an increased volume of sound can be heard in the low frequency range in actual auditory sensation, and sound with reduced distortion can be heard. In these respects, sound quality in actual auditory sensation can be improved.

While in the above-described embodiments each of the gaskets 31 and 32 is formed of a polyurethane foam and the material density is varied to provide the different hardnesses for the gaskets 31 and 32, the gaskets 31 and 32 may be formed of different materials and the material, hardness and configuration in the arrangement of the gaskets 31 and 32 are selected as desired according to the degree of adjustment of acoustic characteristics, the shape and thickness of the panel 21, and other factors. As the material forming the gaskets 31 and 32, polyurethane rubber or silicone rubber, for example, may be used as well as the polyurethane foam.

While in the above-described embodiments the actuator 10 is a piezoelectric actuator using a piezoelectric element (ceramic piezoelectric element), the actuator 10 is not limited to the above-described type of actuator. For example, a super magnetostrictive actuator using a super magnetostrictive element may be used.

## Claims

1. A flat panel speaker having a construction in which an actuator vibrates a panel to radiate sound, the panel being held at a peripheral portion thereof on a frame by gaskets,
wherein the gasket provided at a position opposite from a position at which the actuator is placed has a higher hardness than that of the gasket provided at another position.

2. The flat panel speaker according to claim 1, wherein the panel has a rectangular shape and the actuator is placed along one side of the rectangular shape, and
wherein the gasket having the higher hardness is positioned at the other side opposite from the one side.

3. The flat panel speaker according to claim 1 or 2, wherein the gasket having the higher hardness is made of the same material as the gasket provided at the another position, and has an increased density of the material relative to it.
